(19) Europäisches Patentamt
European Patent Office
Office européen des brevets

(11) EP 0 825 201 B2

(12) NEW EUROPEAN PATENT SPECIFICATION

(45) Date of publication and mention of the opposition decision:
**29.11.2006 Bulletin 2006/48**

(45) Mention of the grant of the patent:
**27.02.2002 Bulletin 2002/09**

(21) Application number: **97109699.5**

(22) Date of filing: **13.06.1997**

(51) Int Cl.:
***C08F 2/50*** (2006.01) ***G03F 7/029*** (2006.01)

# (54) Photocurable composition and curing process therefor

Photohärtbare Zusammensetzung und Härtungsverfahren

Composition photodurcissable et procédé de durcissement

(84) Designated Contracting States:
**DE FR GB NL**

(30) Priority: **23.08.1996 JP 22272896**

(43) Date of publication of application:
**25.02.1998 Bulletin 1998/09**

(73) Proprietor: **SHOWA DENKO KABUSHIKI KAISHA**
**Minato-ku, Tokyo (JP)**

(72) Inventors:
- **Ooga, Kazuhiko**
  **Midori-ku,**
  **Chiba-shi,**
  **Chiba (JP)**
- **Kamata, Hirotoshi**
  **Midori-ku,**
  **Chiba-shi,**
  **Chiba (JP)**
- **Watanabe, Takeo**
  **Midori-ku,**
  **Chiba-shi,**
  **Chiba (JP)**
- **Sugita, Shuichi**
  **Midori-ku,**
  **Chiba-shi,**
  **Chiba (JP)**

(74) Representative: **Strehl Schübel-Hopf & Partner**
**Maximilianstrasse 54**
**80538 München (DE)**

(56) References cited:

| | |
|---|---|
| **EP-A- 0 007 508** | **EP-A- 0 184 095** |
| **EP-A- 0 389 067** | **EP-A- 0 413 657** |
| **EP-A- 0 495 751** | **EP-A- 0 615 980** |
| **EP-B- 0 007 086** | **GB-A- 2 259 704** |
| **GB-A- 2 292 740** | **US-A- 4 308 118** |

- **McGoff-Bethune Inc, Instruction Manual "The Impressor Hand-Held Portable Hardness Tester" Nr. 1260-IN-010-0-03**
- **Römpp Chemie Lexikon, vol. 3, 1997, p. 2160**
- **Bakelite AG, Data Sheet, FM Formmassen "Vergleich von Prüfnormen nach ISO, DIN, ASTM, JIS und BS", p. 31**

EP 0 825 201 B2

Printed by Jouve, 75001 PARIS (FR)

## Description

BACKGROUND OF THE INVENTION

1. Field of the Invention

The present invention relates to a novel photocurable putty material composition and a curing process therefor. More specifically, it relates to a photocurable putty material composition which can be photocured in a short time at low temperature even containing pigments or additives, fillers or dyes with relatively high opacity, and even at a thickness of about 1 cm which causes poor light transmittance, and is suitable for one-pack type putty materials, as well as to a curing process therefor.

2. Description of the Related Art

Two-pack type putty materials have conventionally been used for the purpose of maintenance of automobiles, etc., sealing of joint sections of building materials, etc., and for filling of rough areas of outer body panels during the painting process for railway vehicles, for improved appearance. Examples include unsaturated polyester resins and other radical curing resins which are cured using peroxides or other hardeners, but because these are two-pack types, improvements have been desired to counter the associated problems which include trouble of measurement, failure to add the hardener, limits on the workable time after mixture of the packs, and disposal of the unused mixture. One-pack type putty materials have been proposed as a method of solving these problems, but they introduce other problems involving the physical properties, long curing time and high temperature requirements.

On the other hand, a photocuring reaction using ultraviolet light is used for a wide variety of purposes, including hardening of paints, printing, resin relief printing plates, printed board construction, resists and photomasks, black-and-white or color transfer coloring sheets or coloring sheet construction, etc., and especially with the recent goal of reducing environmental problems, lowering energy consumption and minimizing labor costs, much development has been carried out with an emphasis on polymerization at normal temperature, rapid drying and the ability to be free of solvents, which are features of photopolymerization. Ultraviolet curing applications are also being studied for the use of one-pack type putty materials (such as in Japanese Examined Patent Publication No. 60-30690), but when the cured product has a large thickness or contains additives such as pigments with high opacity, the low transmittance with respect to ultraviolet light has caused the problem of insufficient penetration of the ultraviolet rays to the interior of the curing system, thus resulting in inadequate curing to the interior of the curing system.

Also, in addition to the fact that ultraviolet light sources such as high pressure mercury lamps are not always economical, this method has not been satisfactory from the standpoint of safety as well, considering the possibility of ozone generation and skin cancer.

As examples of using bisacylphosphine oxide-based compounds as polymerization initiators as according to the present invention, there may be cited Japanese Unexamined Patent Publication No. 61-130296, No.2-1401 and No. 5-345790. However, there has been no instance where bisacylphosphine oxide-based polymerization initiators have been applied to putty materials.

Also, as examples of using acylphosphine oxide-based compounds as polymerization initiators according to the present invention, there may be cited Japanese Examined Patent Publication No. 60-8047 and No.63-40799. However, there has been no instance where acylphosphine oxide-based polymerization initiators have been applied to putty materials.

GB-A-2 259 704, EP-A-0 413 657, and EP-A-0 495 751 disclose the features of the preamble of claim 1.

SUMMARY OF THE INVENTION

It is an object of the present invention to provide a novel photocurable putty material composition and a curing process therefor, which overcomes the problems of conventional two-pack type putty materials such as trouble of measurement, failure to add the hardener, limits on the workable time after mixture of the packs and disposal of the mixture, the problems of one-packtype putty materials such as physical properties, curing time and curing temperature, and other problems such as photocurability of ultraviolet photocuring putty materials and light source safety, as well as a curing process therefor.

As a result of much research aimed at overcoming these problems, the present inventors have completed the present invention upon the finding that the aforementioned problems of one-pack type putty materials can be solved by using a visible light polymerization initiator with a longer wavelength region and a specific structure, instead of the conventional ultraviolet polymerization initiators used for one-pack type photocurable putty materials.

In other words, there is provided according to the present invention a novel photocurable composition according

to claim 1 which undergoes photoreaction in a short time and cures at a low temperature, using a photopolymerization initiator comprising a compound represented by general formula (1) or a compound represented by general formula (2), in admixture with a compound with a polymerizable unsaturated bond.

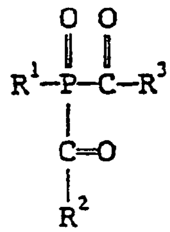

(1)

wherein $R^1$, $R^2$ and $R^3$ each independently represent an alkyl group, aryl group, aralkyl group, alkenyl group, alkynyl group, heterocyclic group, substituted alkyl group, substituted aryl group, substituted aralkyl group, substituted alkenyl group, substituted alkynyl group or substituted heterocyclic group,

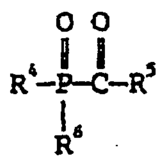

(2)

wherein $R^4$, $R^5$, and $R^6$ each independently represent an alkyl group, aryl group, aralkyl group, alkenyl group, alkynyl group, heterocyclic group, substituted alkyl group, substituted aryl group, substituted aralkyl group, substituted alkenyl group, substituted alkynyl group or substituted heterocyclic group, characterized in that the hardness of the cured product of the cured composition at 25°C as measured with a soft Barcol hardness tester (Model GYZJ 936) is in the range of 1 to 85 and the composition is a putty material.

DESCRIPTION OF THE PREFERRED EMBODIMENTS

According to the present invention, a putty material is a filler used for the purpose of improving the appearance of vehicles and the like, or a filler used to improve sealings for building materials, glass and the like. A more specific description is found, for example, under "putty" in Illustrated Dictionary of Plastics Terminology (7th edition, published June 30, 1988, Nikkan Kogyo Shimbun Co.).

One of the features of the photopolymerization initiator to be used in the invention is the use of a photopolymerization initiator consisting of a bisacylphosphine oxide compound represented by general formula (1) or an acylphosphine oxide compound represented by general formula (2). These initiators are sensitive to light in a longer wavelength region than conventional UV initiators (visible light region of 400 nm and greater) and have excellent light permeability, while also generating acyl radicals and phosphynoyl radicals upon cleavage by light irradiation, and thus have higher polymerization initiating efficiency than conventional UV initiators. Also, according to the invention, since polymerization initiators with sensitivity in the visible light and/or near infrared light region which can be used together with the compound represented by general formula (1) or the compound represented by general formula (2) have sensitivity in a longer wavelength region than the initiator represented by general formula (1) or general formula (2), the light transmittance is even more excellent.

As concrete examples of bisacylphosphine oxide compounds of general formula (1) to be used according to the invention there may be mentioned bis(2,6-dichlorobenzoyl)-phenylphosphine oxide, bis(2,6-dichlorobenzoyl)-2,5-dimethylphenylphosphine oxide, bis(2,6-dichlorobenzoyl)-4-ethoxyphenylphosphine oxide, bis(2,6-dichlorobenzoyl)-4-biphenylphosphine oxide, bis(2,6-dichlorobenzoyl)-4-propylphenylphosphine oxide, bis(2,6-dichlorobenzoyl)-2-naphthylphosphine oxide, bis(2,6-dichlorobenzoyl)-l-naphthylphosphine oxide, bis(2,6-dichlorobenzoyl)-4-chlorophenylphosphine oxide, bis(2,6-dichlorobenzoyl)-2,4-dimethoxyphenylphosphine oxide, bis(2,6-dichlorobenzoyl)-decylphosphine oxide, bis(2,6-dichlorobenzoyl)-4-octylphenylphosphine oxide, bis(2,6-dichlorobenzoyl)-2,5-dimethylphenylphosphine oxide, bis(2,6-dichlorobenzoyl)-phenylphosphine oxide, bis(2,4,6-trimethylbenzoyl)-2,5-dimethylphenylphosphine oxide, bis(2,6-dichloro-3,4,5-trimethoxybenzoyl)-2,5-dimethylphenylphosphine oxide, bis(2,6-dichloro-3,4,5-trimethoxybenzoyl)-4-ethoxyphenylphosphine oxide, bis(2-methyl-1-naphthoyl)-2,5-dimethylphenylphosphine oxide, bis(2-methyl-1-naphthoyl)-2,5-phenylphosphine oxide, bis(2-methyl-1-naphthoyl)-4-biphenylphosphine oxide, bis(2-methyl-1-naphthoyl)-4-ethoxybiphenylphosphine oxide, bis(2-methyl-1-naphthoyl)-2-naphthylphosphine oxide, bis(2-methyl-1-naphthoyl)-4-propylphenylphosphine oxide, bis(2-methyl-1-naphthoyl)-2,5-dimethylphenylphosphine oxide, bis(2-methyl-1-naphthoyl)-4-methoxyphenylphosphine oxide, bis(2-methyl-1-naphthoyl)-4-biphenylphosphine oxide, bis(2-chloro-1-naphthoyl)-2,5-dimethylphenylphosphine oxide and bis(2,6-dimethoxybenzoyl)-2,4,4-trimethylpentylphosphine oxide.

As concrete examples of acylphosphine oxide compounds of general formula (2) to be used according to the invention there may be mentioned 2,4,6-trimethylbenzoyl-diphenylphosphine oxide, 2,6-diphenylbenzoyl-diphenylphosphine oxide, 2,6-dimethoxybenzoyl-diphenylphosphine oxide, 2,3,5,6-tetramethylbenzoyl-diphenylphosphine oxide, 2,6-dichlorobenzoyi-diphenylphosphine oxide, 2,3,6-trimethylbenzoyl-diphenylphosphine oxide, 2-phenyl-6-methylbenzoyl-diphenylphosphine oxide, 2,6-dibromobenzoyl-diphenylphosphine oxide, 2,8-dimethylnaphthalene-1-carbonyl-diphenylphosphine oxide, 1,3-dimethoxynaphthalene-2-carbonyl-diphenylphosphine oxide, methyl 2,4,6-trimethylbenzoyl-phenylphosphinate, methyl 2,6-dimethylbenzoyl-phenylphosphinate and ethyl 2,6-dichlorobenzoyl-phenylphosphinate.

The object of the present invention may usually be achieved by using an initiator represented by general formula (1) or an initiator represented by general formula (2) in an amount of at least 0.01 wt% based on 100 parts by weight of the total of the polymerizable unsaturated compound component. At a lower content the polymerization may not proceed to an adequate degree. The range is preferred to be 0.03 to 20 wt%. A more preferred range is 0.05 to 15 wt%. An excess amount is not preferred from an economical standpoint. Also, one type of initiator may be used, or 2 or more types may be used in combination.

Another feature of the photopolymerization initiator to be used according to the invention is that a compound with sensitivity in the visible light and/or near infrared light region may be used together with the photopolymerization initiator of general formula (1) or general formula (2). As examples of combinable compounds with sensitivity in the visible light and/or near infrared light region there may be mentioned combinations of visible light and/or near infrared light-absorbing cationic dyes of general formula (3) and boron-containing compounds of general formula (4).

$$D^+ \cdot A^- \qquad (3)$$

wherein $D^+$ represents a cationic dye with absorption in the visible light and/or near infrared light region, and $A^-$ represents any anion.

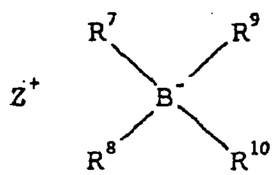

(4)

wherein $Z^+$ represents a cation, and $R^7$, $R^8$, $R^9$ and $R^{10}$ each independently represent an alkyl group, aryl group, aralkyl group, alkenyl group, alkynyl group, silyl group, heterocyclic group, halogen atom, substituted alkyl group, substituted aryl group, substituted aralkyl group, substituted alkenyl group, substituted alkynyl group or substituted silyl group.

The cationic dye of general formula (3) may be a dye with absorption in any desired wavelength region, specifically in the range of 500 nm to 2000 nm, and preferably in the range of 500 nm to 1500 nm.

As preferred examples of cations ($D^+$) of the cationic dye there may be mentioned cations of methine-, polymethine-, indoline-, cyanine-, xanthene-, thiazine-, diarylmethane-, triarylmethane- and pyrillium-series cationic dyes. As representative cationic dyes there may be mentioned, for example, the dyes listed in Table 1.

Table 1

| No. | Chemical structure | Maximum absorption wavelength (type of solvent) |
|---|---|---|
| 1 | 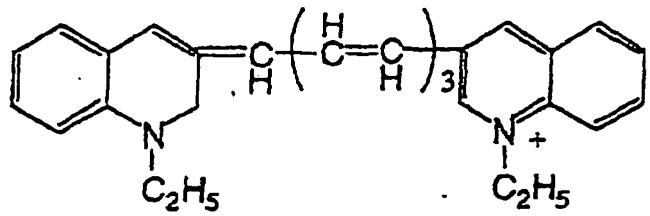 | 820 nm (TMPT) |
| 2 | 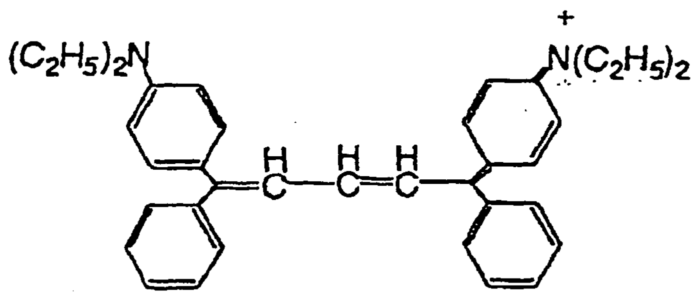 | 830 nm (TMPT) |
| 3 | 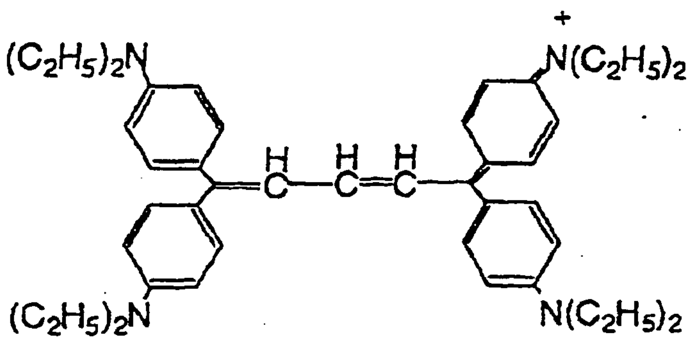 | 822 nm (TMPT) |
| 4 | 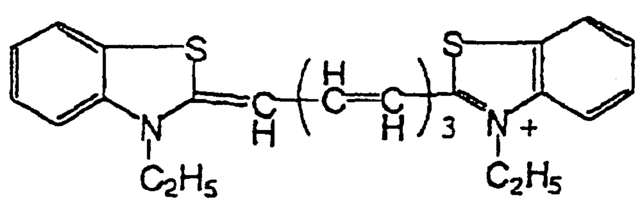 | 768 nm (TMPT) |
| 5 | 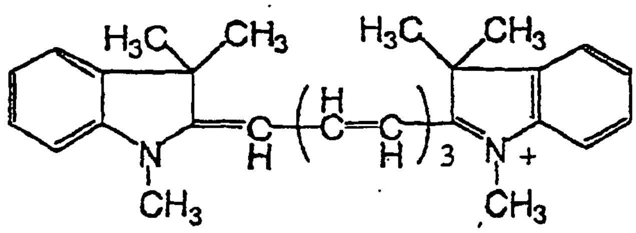 | 748 nm (TMPT) |

(continued)

| No. | Chemical structure | Maximum absorption wavelength (type of solvent) |
|---|---|---|
| 6 | 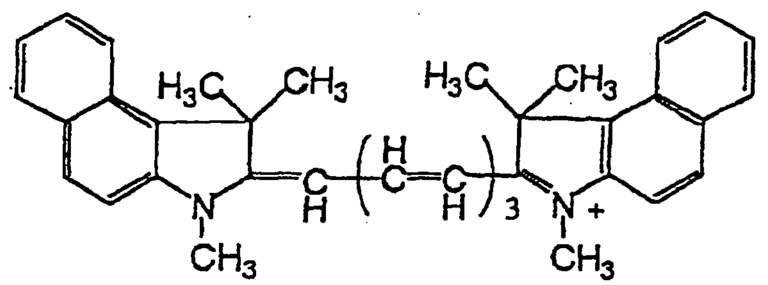 | 785 nm (TMPT) |
| 7 | 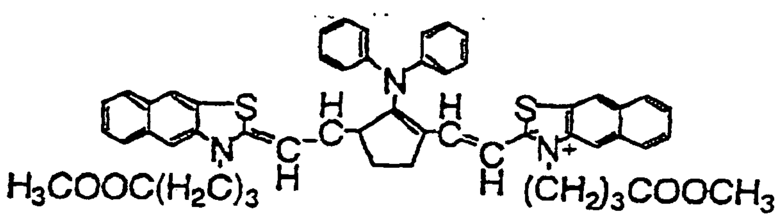 | 828 nm (TMPT) |
| 8 | 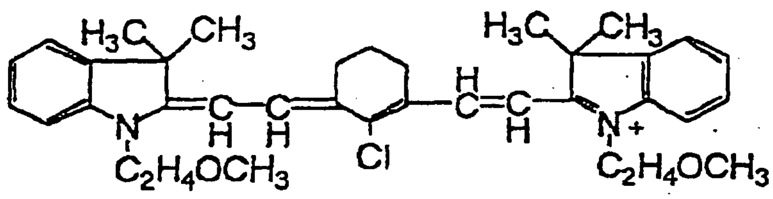 | 787 nm (TMPT) |
| 9 | 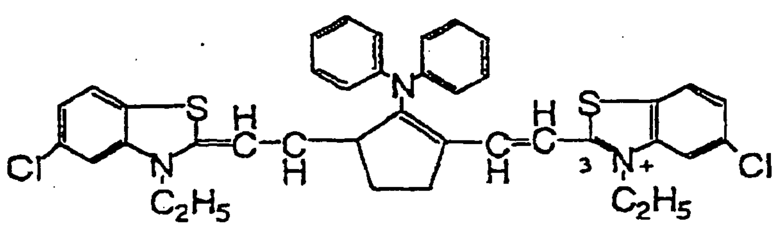 | 818 nm (TMPT) |
| 10 | 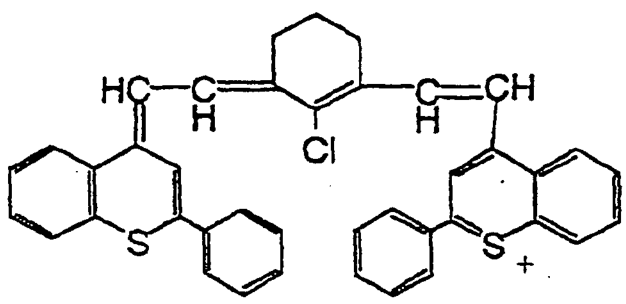 | 1080 nm (TMPT) |

(continued)

| No. | Chemical structure | Maximum absorption wavelength (type of solvent) |
|---|---|---|
| 11 | 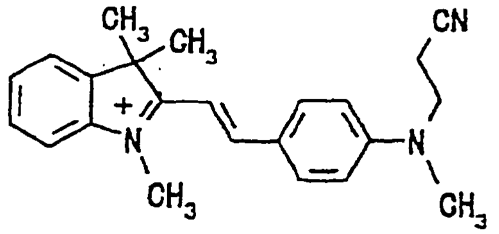 | 522 nm (acetonitrile) |
| 12 | 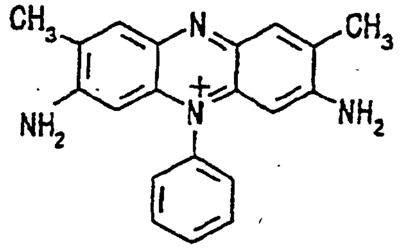 | 528 nm (chloroform) |
| 13 | 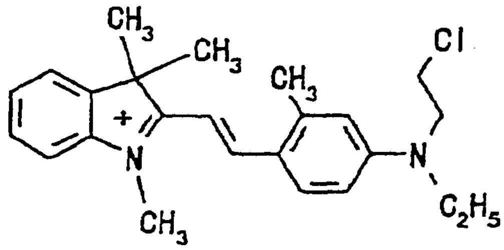 | 544 nm (acetonitrile) |
| 14 | 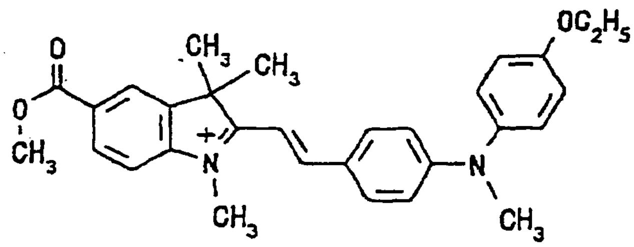 | 559 nm (acetonitrile) |
| 15 | 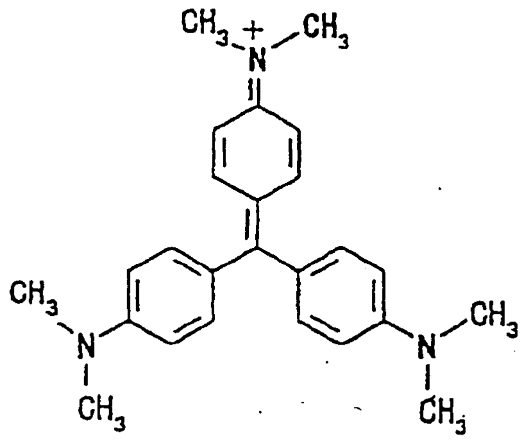 | 589 nm (acetonitrile) |

(continued)

| No. | Chemical structure | Maximum absorption wavelength (type of solvent) |
|---|---|---|
| 16 | 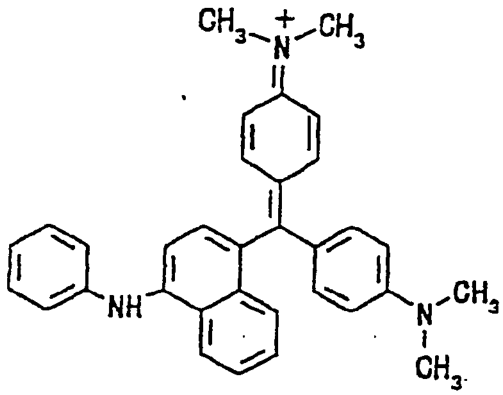 | 613 nm (acetonitrile) |
| 17 | 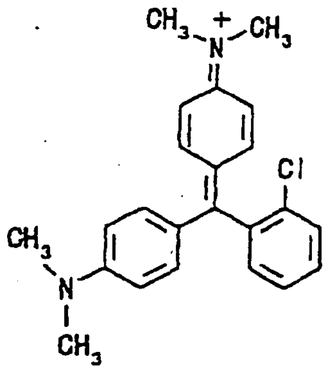 | 632 nm (acetonitrile) |
| 18 | 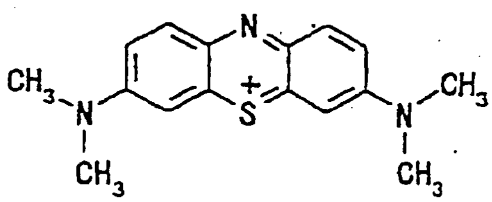 | 658 nm (chloroform) |
| 19 | 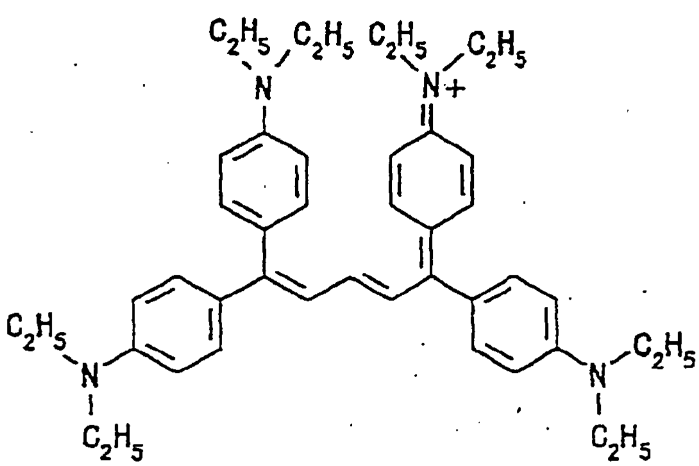 | 820 nm (trimethylolpropane triacrylate) |
| TMPT refers to trimethylolpropane trimethacrylate. | | |

The counter anion A may be any desired anion, but four-coordinate borate anions represented by the following general formula (5) are particularly preferred.

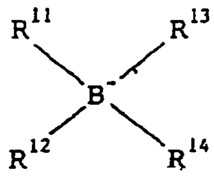

(5)

wherein $R^{11}$, $R^{12}$, $R^{13}$ and $R^{14}$ each independently represent an alkyl group, aryl group, aralkyl group, alkenyl group, alkynyl group, silyl group, heterocyclic group, halogen atom, substituted alkyl group, substituted aryl group, substituted aralkyl group, substituted alkenyl group, substituted alkynyl group or substituted silyl group.

As specific examples there may be mentioned n-butyltriphenyl borate ion, n-octyltriphenyl borate ion, triphenylsilyltriphenyl borate ion, di-n-dodecyldiphenyl borate ion, tetraphenyl borate ion and tri-n-butyl(dimethylphenylsilyl) borate ion, and more specifically there may be mentioned the anions described in a patent specification already filed by the present inventors (Japanese Unexamined Patent Publication No. 6-75374).

As specific examples of four-coordinate borate ions as the anions in the boron-containing compound represented by general formula (4) there may be mentioned n-butyftriphenyl borate ions, n-octyltriphenyl borate ions, triphenylsilyltriphenyl borate ions, n-butyltrianisyl borate ion, n-butyltri(p-fluorophenyl) borate ion, n-butyltd(p-trifluoromethylphenyl) borate ion, di-n-dodecyldiphenyl borate ion, tetraphenyl borate ion, triphenylnaphthyl borate ion, tetrabutyl borate ion and tri-n-butyl(dimethylphenylsilyl) borate ion. Also, as the cation ($Z^+$) in the formula there may be mentioned quaternary ammonium cations represented by general formula (6):

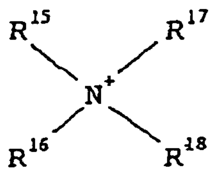

(6)

wherein $R^{15}$, $R^{16}$, $R^{17}$ and $R^{18}$ each independently represent a hydrogen atom, alkyl group, aryl group, aralkyl group, alkenyl group, alkynyl group, heterocyclic group, halogen atom, substituted alkyl group, substituted aryl group, substituted aralkyl group, substituted alkenyl group or substituted alkynyl group, quaternary pyridinium cations, quaternary quinolinium cations, diazonium cations, tetrazonium cations, phosphonium cations, (oxo)sulfonium cations, metal cations such as sodium, potassium, lithium, magnesium and calcium, organic oxocations of flavinium and pyranium salts, carbocations such as tropillium and cyclopropylium, iodonium and other halogenium ions, and cations of compounds of metals such as arsenic, cobalt, palladium, chromium, titanium, tin and antimony, which are described in more detail in Japanese Unexamined Patent Publication No. 6-75374.
These cationic dyes and boron-containing catalysts may be used alone or in combinations of 2 or more.

When a cationic dye of general formula (3) is combined with a boron-containing catalyst of general formula (4), decomposition occurs by visible light and/or near infrared light causing decoloration of the cationic pigment and initiating polymerization, to thus allow curing of compositions with high opacity. The decoloration reaction of the cationic dye is irreversible, and therefore the color of the cationic dye does not interfere with the color phase of the cured product.

When a cationic dye of general formula (3) is used with a boron-containing catalyst of general formula (4), they may generally be used in a proportion of 10:1-1:50 (molar ratio), but for completeness of the curing reaction and the decoloration reaction of the dye, the boron-containing catalyst may preferably be used in a larger amount than the cationic dye. That is, a proportion in the range of 1:1-1:50 (molar ratio) is particularly preferred. Also, the photopolymerization initiator can usually be used in an amount of at least 0.01 wt% of the polymerizable component, in order to achieve the object of the present invention. At a lower amount the polymerization may not proceed to an adequate degree. A more preferred range is 0.05-10 wt%. An excessive amount is not preferred from an economical standpoint. Also, two or more types of cations and boron-containing catalysts may be used in combination.

The photopolymerization initiator which is a bisacylphosphine oxide compound represented by general formula (1) or an acylphosphine oxide compound represented by general formula (2) is sensitive to light in a wavelength region of 200-500 nm, and it has been found to be extremely stable in curing compositions at 40˚C or below. Consequently, the photocurable composition of the invention has storage stability unachievable by the prior art, and sufficient curability

can be maintained even after 6 months or longer.

The essential wavelength for the light used according to the invention may be in the wavelength region of 400-500 nm. With only light of wavelengths shorter than 400 nm the light transmittance may be drastically lowered, while it is also not preferred in terms of safety. Light of only wavelengths longer than 500 nm is not preferred because of a lack of sensitivity of the bisacylphosphine oxide compound represented by general formula (1) or the acylphosphine oxide compound represented by general formula (2).

The combination ratio (weight ratio) of the compound with sensitivity in the visible light and/or near infrared light region and the photopolymerization initiator of general formula (1) or general formula (2) as used according to the invention cannot be specified for all cases since it depends on the thickness, light transmittance, etc. of the cured product, but in cases where the curing thickness exceeds 1 cm, it is preferably at least 1/30 to ensure curing at the deep portions. It Is even more preferred to be at least 1/20. However, as explained above, although the photopolymerization initiators of general formula (1) and general formula (2) are stable in the composition, since the visible light and/or near infrared photopolymerization initiator according to the invention can be destabilized depending on the types of components in the composition, thus lowering the storage stability, the photopolymerization initiator of general formula (1) or general formula (2) may be used alone as long as there is no problem with the curability of the composition, and even if a visible light and/or near infrared photopolymerization initiator is used it is preferably used at the minimal amount to ensure the necessary curability to the deep portions.

Representative polymerizable unsaturated compounds to be used for the invention include unsaturated polyester resins, vinyl ester resins and curable (meth)acrylic resins.

The unsaturated polyester may be one which is obtained by reacting an acid or its anhydride with an alcohol by a publicly known method.

As specific examples of acids or their anhydrides there may be mentioned saturated polybasic acids with no active unsaturated bonds and their anhydrides, such as phthalic anhydride, isophthalic acid, terephthalic acid, tetrahydrophthalic acid and adipic acid; unsaturated polybasic acids with active unsaturated bonds and their anhydrides, such as fumaric acid, maleic anhydride, maleic acid and itaconic acid; and as necessary monocarboxylic acids such as benzoic acid, abietic acid and maleic acid mono(dicyclopentenyl) ester. Also, as specific examples of alcohols there may be mentioned polyhydric alcohols such as ethylene glycol, propylene glycol, diethylene glycol, dipropylene glycol, 1,2-butanediol, 1,3-butanediol, 1,5-pentanediol, 1,6-hexanediol, 2-methyl-1,3-propanediol, 2,2-dimethyl-1,3-propanediol, cyclohexane-1,4-dimethanol, ethylene oxide adduct of bisphenol A, propylene oxide adduct of bisphenol A, etc.

The vinyl ester resin is produced by a known process, of which there may be mentioned epoxy (meth)acrylates obtained by reacting (meth)acrylic acid with an epoxy resin, and polyester (meth)acrylates obtained by reacting an epoxy compound containing an $\alpha,\beta$-unsaturated carboxylic acid ester group with a terminal carboxylated polyester obtained from a saturated dicarboxylic and/or unsaturated dicarboxylic acid and a polyhydric alcohol.

As epoxy resins for the raw material of the vinyl ester resin there may be mentioned bisphenol A diglycidyl ether and high molecular homologs thereof, and novolac-type polyglycidyl ethers.

As unsaturated dicarboxylic acids there may be mentioned dicarboxylic acids with no active unsaturated groups, such as phthalic acid, isophthalic acid, terephthalic acid, tetrahydrophthalic acid, adipic acid and sebacic acid. As unsaturated dicarboxylic acids there may be mentioned dicarboxylic acids with active unsaturated groups, such as fumaric acid, maleic acid, maleic anhydride and itaconic acid.

As examples of polyhydric alcohols there may be mentioned polyhydric alcohols such as ethylene glycol, propylene glycol, diethylene glycol, dipropylene glycol, 1,2-butanediol, 1,3-butanediol, 1,5-pentanediol, 1,6-hexanediol, 2-methyl-1,3-propanediol, 2,2-dimethyl-1,3-propanediol, cyclohexane-1,4-dimethanol, ethylene oxide adduct of bisphenol A, propylene oxide adduct of bisphenol A, etc.

Representative of epoxy compounds containing $\alpha,\beta$-unsaturated carboxylic acid ester groups is glycidyl methacrylate.

Curable acrylic resins include, for example, (meth)acrylates such as diethyleneglycol diacrylate, 1,6-hexanediol dimethacrylate, trimethylolpropane triacrylate, pentaerythritol trimethacrylate and pentaerythritol tetraacrylate and urethane acrylates produced by reaction of hydroxyalkyl (meth)acrylates with compounds which have at least 2 isocyanate groups, and also include oligomers which are products of reacting acrylic acid and/or methacrylic acid with an adduct of a polyhydric alcohol and ethylene oxide; products of reacting acrylic acid and/or methacrylic acid with an adduct of the aforementioned polyhydric alcohol and propylene oxide; and products of reacting acrylic acid and/or methacrylic acid with an adduct of the aforementioned polyhydric alcohol and $\varepsilon$-caprolactone.

As polymerizable unsaturated compounds there may be used the following types of resins in addition to unsaturated polyester resins, curable (meth)acrylic resins and vinyl ester resins. Such resins include resins obtained by condensing the terminal hydroxyl group of a polyester with (meth)acrylic acid, polyurethane resins containing ethylenically unsaturated groups, epoxy resins containing ethylenically unsaturated groups, phosphorous epoxy resins containing ethylenically unsaturated groups, silicone resins containing ethylenically unsaturated groups and melamine resins containing ethylenically unsaturated groups.

If necessary, various types of fillers may be added to the photocurable composition of the invention. As fillers to be used for the invention there may be mentioned organic and inorganic substances of various shapes including powders, spheres, whiskers and scales, as well as composites and mixtures thereof.

Specific examples of inorganic fillers which may be used include known ones such as calcium carbonate, talc, clay, glass powder, silica, aluminum hydroxide, barium sulfate, titanium oxide, asbestos and alumina. These inorganic fillers may also be used in combinations of two or more types.

As specific examples of organic fillers there may be mentioned polystyrene, polyvinyl acetate, polymethyl methacrylate, chlorinated polyethylene, chlorinated polypropylene, polyester, chlorinated polyester, polyvinylidene chloride microballoons and polyacrylonitrile microballoons. These organic fillers may also be used in combinations of two or more types. An organic filler and an inorganic filler may also be used together.

These inorganic fillers and/or organic fillers do not necessarily need to be added when the polymerizable unsaturated compound used or the reactive diluent explained later has a low volume shrinkage rate during polymerization, but when it has a high volume shrinkage rate during polymerization, fillers should be added for the purpose of reducing shrinkage. When added, preferably the volume shrinkage rate of the photocurable composition during polymerization is 10% or lower and the light transmittance is not drastically lowered, and generally the amount is no more than 500 parts by weight, preferably no more than 200 parts by weight, and more preferably no more than 150 parts by weight based on 100 parts by weight of the total combined amount of the polymerizable unsaturated compound and the reactive diluent explained below. If the filler is present in too large an amount, the light transmittance may be lowered and the curing reaction may fail to proceed sufficiently, thus lowering the flexibility of the cured product and possibly leaving it brittle.

Also, in order to increase kneadability and impregnability between the polymerizable unsaturated compound and filler, and adjust the hardness, strength, chemical resistance and water resistance of molded products, a reactive diluent may also be added to the composition of the invention, as a low viscosity compound with one ethylenically unsaturated group in the molecule, such as styrene monomer or methyl methacrylate. The amount of the reactive diluent to be used is not critical, but it is generally 0-250 parts by weight, and preferably 20-150 parts by weight, based on 100 parts by weight of the unsaturated polyester resin, vinyl ester resin or curable (meth)acrylic resin. If used in an amount exceeding 250 parts, the chemical resistance of the cured product to solvents and the like may be impaired.

As monomers which may be used as reactive diluents there may be mentioned aromatic monomers such as styrene, $\alpha$-methylstyrene, p-methylstyrene and chlorostyrene; (meth)acrylate monomers such as methyl methacrylate, isobutyl (meth)acrylate, isobomyl (meth)acrylate, dicyclopentenyl (meth)acrylate, dicyclopentenyloxyethyl (meth)acrylate, 2-hydroxy-3-phenoxypropyl (meth)acrylate, 2-hydroxyethyl (meth)acrylate, 2-hydroxypropyl (meth)acrylate and polyoxyethylene (meth)acrylate; N-substituted acrylamides such as N,N-dimethylacrylamide, N,N-diethylacrylamide and N-acryloylmorpholine; nitrogen-containing unsaturated monomers such as N-vinylpyrrolidone, N-vinyl-N-methylacetamide, N-vinylformamide and vinylpyridine; (meth)acrylic acid, vinyl acetate, etc. Other reactive diluents include phosphorus-containing polymerizable unsaturated monomers, adduct of isocyanate compounds such as butyl isocyanate and phenyl isocyanate with hydroxyl group-containing monomers such as 2-hydroxy-3-phenoxypropyl (meth) acrylate, 2-hydroxyethyl (meth)acrylate and 2-hydroxypropyl (meth)acrylate, and adducts of phosphoric acid and these hydroxyl group-containing monomers.

In addition, any of various pigments or commonly used coating additives such as levelling agents, plasticizers, foaming agents, thickening agents, polymerization inhibitors, antioxidants, etc. may also be added to the composition of the invention if necessary, so long as the storage stability, curability and properties of the cured product are not impaired.

The curing of the composition of the invention is usually carried out according to the following procedure. First, the polymerizable compound, the polymerization initiator and if necessary a filler or additive are thoroughly kneaded together to obtain a composition. Next, the composition is applied to a body to be coated to the desired thickness. Although the thickness may be determined based on the need and purpose, it generally be in the range of 1 mm to 1 cm. Application to a greater thickness than necessary is not desirable since extra time may be required for curing, and in some cases sufficient curing cannot be achieved to the deep portions of the composition.

The photocurable composition of the invention may be suitably used as a photocurable putty material composition. When used as a putty material composition, the mixing proportion of the composition is set so that the hardness of the composition cured with the required light irradiation as measured at 25˚C with a soft Barcol hardness tester (Model GYZJ 936) is In the range of 1-85, preferably the range of 10-75 and more preferably the range of 15-70, on both the front and back sides (measured after peeling from the substrate).

If the value as measured with a soft Barcol hardness tester is less than 1, practical use may become more difficult in terms of strength, and if it exceeds 85, smoothing treatment and other working of the surface becomes more difficult, i.e. the surface may not be easily abraded.

The light source used for curing according to the invention may be any light source capable of irradiation of light with spectral distribution in the photosensitive wavelength region of the initiator in the composition and with an intensity which can induce a photoreaction, such as a xenon lamp, halogen lamp, incandescent lamp, metal halide lamp

or sunlight. Two or more different types of light sources may also be used together to match the photosensitive wavelength of the initiator.

The light intensity required for curing of the composition of the invention will differ depending on the photosensitivity (light sensitivity) of the initiator, the curability of the polymerizable compound, the type and amount of filler, the thickness of the composition coating, etc., but it may be 10 mJ/cm$^2$ or greater, and preferably 100 mJ/cm$^2$ or greater. If the light intensity is too low the photoreaction may fail to proceed sufficiently, often resulting in inadequate curing reaction of the composition and non-uniform curing in the direction of depth.

The light irradiation time cannot be specified for all cases since it will differ depending on the effective wavelength region, output and irradiation distance of the light source and the thickness of the molding material, but the irradiation may be carried out for 0.01 hour or more, and preferably 0.16 hour or more.

For the photocuring reaction, the light irradiation is preferably carried out under a low oxygen concentration in order to reduce polymerization interference on the composition surface by oxygen. For example, after coating of the composition, the surface of the composition is covered with a light-permeable film or the like priorto the light irradiation in an inert gas atmosphere such as nitrogen, argon or carbon dioxide, or in air while blowing the inert gas onto the surface of the composition, to allow curing to proceed while minimizing the oxygen concentration.

The photocurable composition of the present invention is used basically as a one-pack type putty material, but depending on the case it may of course be used as a conventional two-pack type putty material, wherein the initiator is mixed therewith just prior to use.

The present invention will now be illustrated with reference to the following examples which, however, are in no way intended to restrict the Invention. Unless otherwise specified, the term "parts" in the examples and comparative examples refers to parts by weight. (Examples 1, 2, 4, 5, 7, 9, 10 and 14 are no examples of the present invention).

Examples 1-3

To 50 parts of a vinyl ester resin, tradename: EBECRYL3702 (product of DAICEL-UCB Co.):EBECRYL111 (product of DAICEL-UCB Co.) = 7:3 (w/w) there were added the initiators listed in Table 2, and each mixture was thoroughly kneaded by stirring for 15 minutes with a high-speed dissolver. Samples of the freshly kneaded composition which had been stored in darkness at 25˚C for 3 months after kneading and stored in darkness at 25˚C for 6 months after kneading were used for a curing experiment

Comparative Example 1

The same procedure was carried out as in Example 1, except that the ultraviolet photopolymerization initiator 2-hydroxy-2-methyl-1-phenylpropan-1-one (see Table 2 for structural formula and addition amount) was used as the photopolymerization initiator.

Examples 4-6

To 50 parts of an unsaturated polyester resin with about 350 unsaturated group equivalents, tradename:

Rigolac 2141 (containing styrene, product of Showa Highpolymer, KK.) there were added the Initiators listed in Table 2 and a filler (polyester resin, 20 parts, tradename: Bylon 500, product of Toyo Spinning, KK.), and each mixture was thoroughly kneaded by stirring for 15 minutes with a high-speed dissolver. Samples of the freshly kneaded composition which had been stored in darkness at 25˚C for 3 months after kneading and stored in darkness at 25˚C for 6 months after kneading were used for a curing experiment.

Comparative Example 2

The same procedure was carried out as in Example 4, except that the Ultraviolet photopolymerization initiator 2-hydroxy-2-methyl-1-phenylpropan-1-one (see Table 2 for structural formula and addition amount) was used as the photopolymerization initiator.

Comparative Example 3

To a combination of 50 parts of an unsaturated polyester resin with about 350 unsaturated group equivalents, tradename: Rigolac 2141 (containing styrene, product of Showa Highpolymer, Co.), one part of the photopolymerization initiator camphorquinone and one part of the reducing agent N,N-dimethyl-p-toluldine, there were added one part of the thermal polymerization initiator azobisisobutyronitrile and a filler (polyester resin, 20 parts, tradename: Bylon 500), and

the mixture was thoroughly kneaded by stirring for 15 minutes with a high-speed dissolver. A sample which had been stored in darkness at 25°C for 3 months after kneading was gelated.

Examples 7, 8

To 35 parts of a vinyl ester resin, tradename: EBECRYL3702 (product of DAICEL-UCB, Co.) and 15 parts of isobornyl acrylate there were added the initiators listed in Table 2 and a filler (5 parts of talc, average particle size: 10 μm), and each mixture was thoroughly kneaded by stirring for 15 minutes with a high-speed dissolver. Samples of the freshly kneaded composition which had been stored in darkness at 25°C for 3 months after kneading and stored in darkness at 25°C for 6 months after kneading were cured by the process described hereunder.

Comparative Example 4

The same procedure was carried out as in Example 7, except that the ultraviolet photopolymerization initiator 1-hydroxycyclohexyl phenyl ketone (see Table 2 for structural formula and addition amount) was used as the initiator.

Examples 9-12

To 35 parts of a vinyl ester resin, tradename: Epoxyester 3002M (product of Kyoeisha Chemical, Co.) and 15 parts of dicyclopentenyloxyethyl acrylate there were added the initiators listed in Table 1 and a filler (20 parts of toluene-removed product of chlorinated polypropylene, tradename: Superchlon-214, product of Nippon Paper, Ind. Co.), and each mixture was thoroughly kneaded by stirring for 15 minutes with a high-speed dissolver. Samples of the freshly kneaded composition which had been stored in darkness at 25°C for 3 months after kneading and stored in darkness at 25°C for 6 months after kneading were used for a curing experiment.

Comparative Example 5

The same procedure was carried out as in Example 9, except that the ultraviolet photopolymerization initiator 1-[4-(2-hydroxyethoxy)-phenyl]-2-hydroxy-2-methyl-1-propan-1-one (see Table 2 for structural formula and addition amount) was used as the initiator.

Examples 13-14

To a curable acrylic resin, tradename: EBECRYL585 (mixture of chlorinated polyester:tripropyleneglycol diacrylate = 6:4 (w/w), product of DAICEL-UCB, Co.) there were added the initiators listed in Table 2, and each mixture was thoroughly kneaded by stirring for 15 minutes with a high-speed dissolver. Samples of the freshly kneaded composition which had been stored in darkness at 25°C for 3 months after kneading and stored in darkness at 25°C for 6 months after kneading were used for a curing experiment.

Table 2

| Example No. | Type of initiator | Amount of initiator (based on resin) |
|---|---|---|
| 1 and 4 | 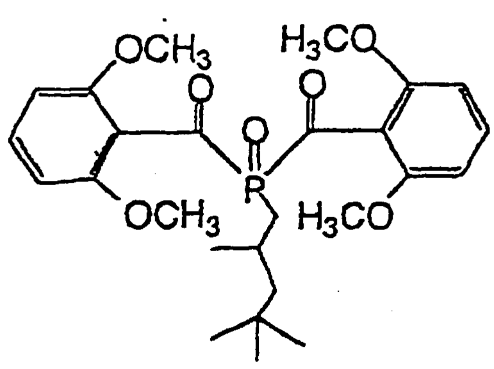 | 2 wt % |

(continued)

| Example No. | Type of initiator | Amount of initiator (based on resin) |
|---|---|---|
| 2 and 5 | 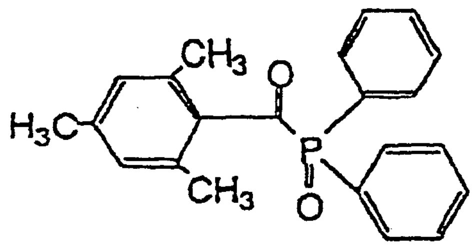 | 4 wt % |
| 3 and 6 | 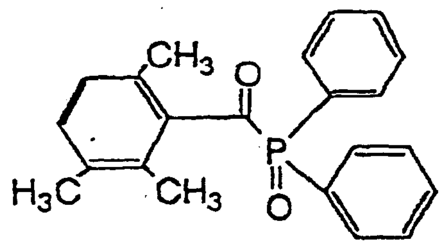 | 4 wt % |
| | 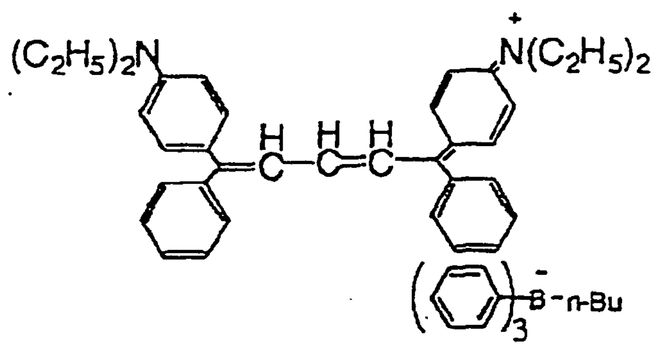 | 1 wt % |
| | 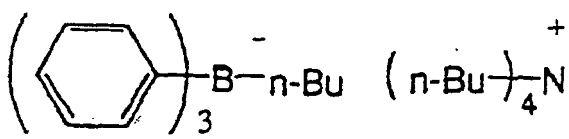 | 2 wt % |
| 7 | 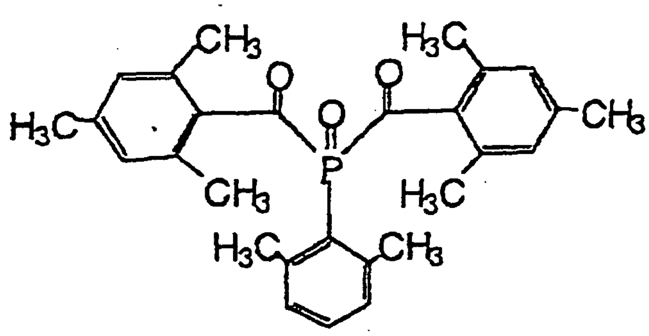 | 3 wt% |

(continued)

| Example No. | Type of initiator | Amount of initiator (based on resin) |
|---|---|---|
| 8 | 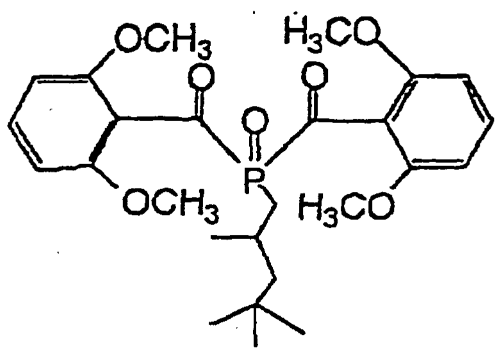 | 1 wt% |
| | 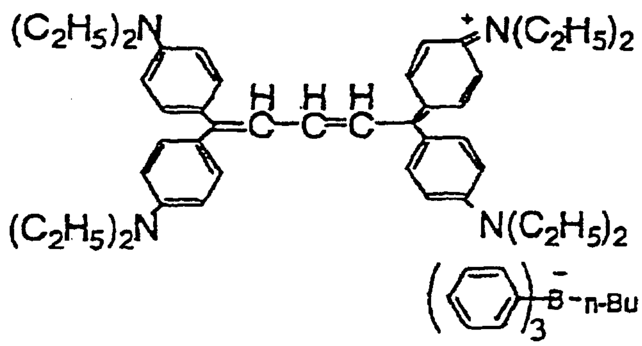 | 1 wt% |
| | 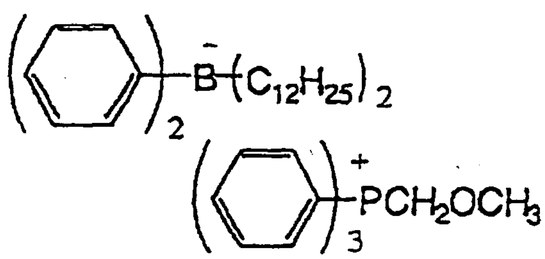 | 3 wt% |
| 9 | 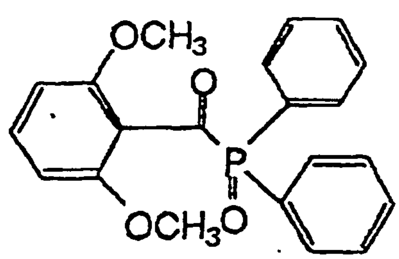 | 4 wt% |

(continued)

| Example No. | Type of initiator | Amount of initiator (based on resin) |
|---|---|---|
| 10 | 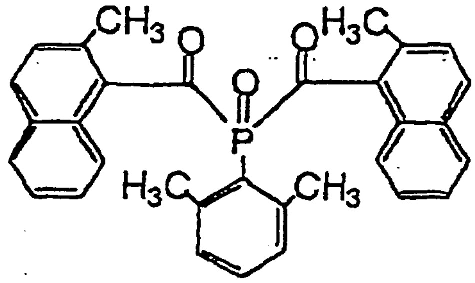 | 2 wt% |
| 11 | 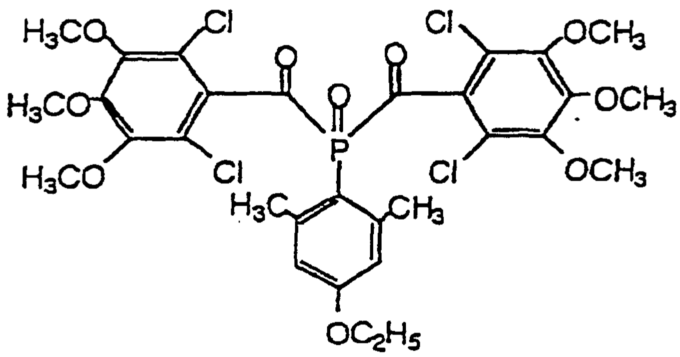 | 2 wt% |
| | 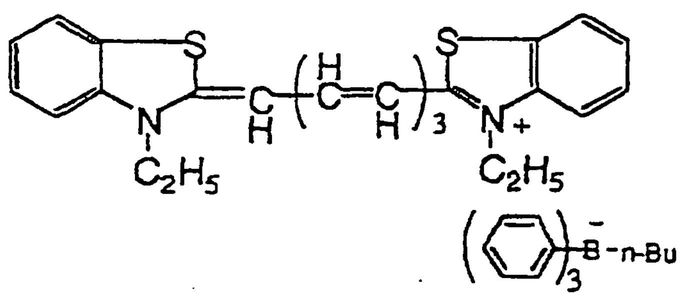 | 1 wt% |
| | 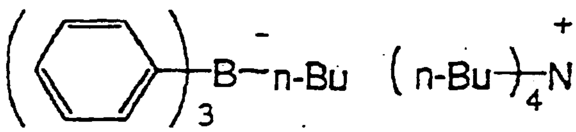 | 3 wt% |

(continued)

| Example No. | Type of initiator | Amount of initiator (based on resin) |
|---|---|---|
| 12 | 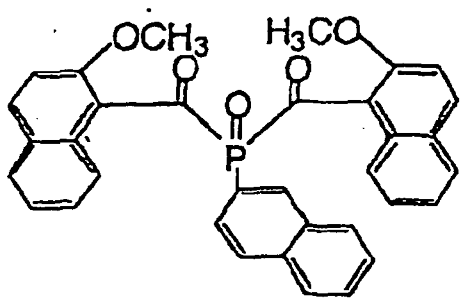 | 3 wt% |
| | 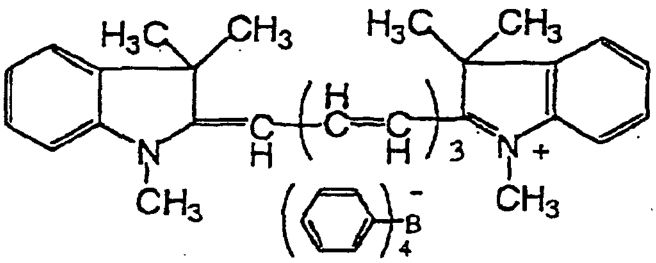 | 1 wt% |
| | 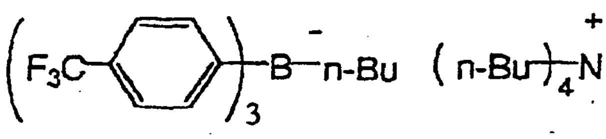 | 3 wt% |
| 13 | 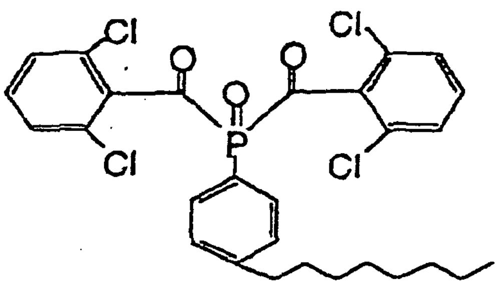 | 6 wt% |
| | 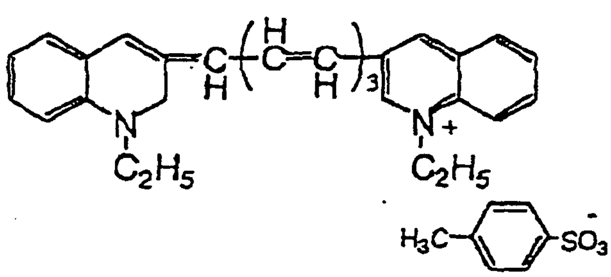 | 2 wt% |
| | 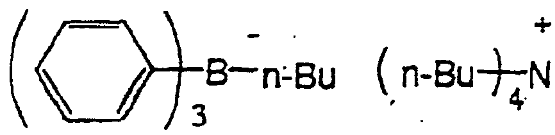 | 3 wt% |

(continued)

| Example No. | Type of initiator | Amount of initiator (based on resin) |
|---|---|---|
| 14 | 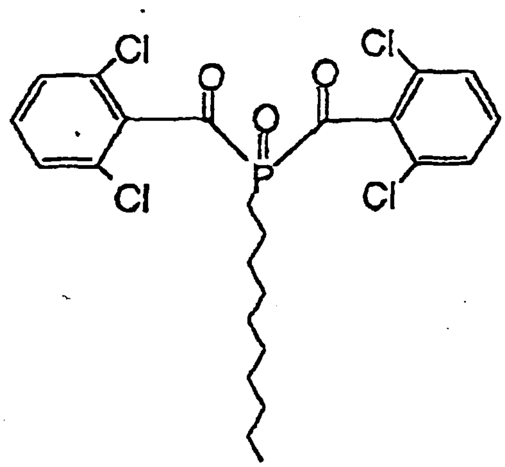 | 3 wt% |
| Comparative 1 and 2 | 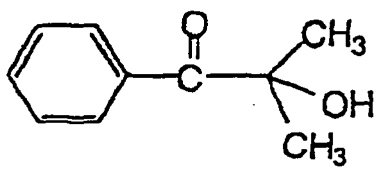<br>UV light polymerization initiator | 4 wt% |
| Comparative 4 | 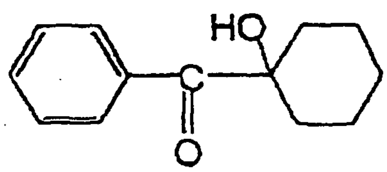<br>UV light polymerization initiator | 3 wt% |
| Comparative 5 | 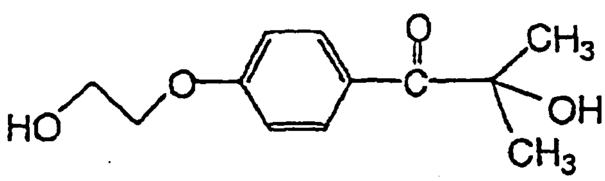<br>UV light polymerization initiator | 3 wt% |

Curing experiment

Each of the compositions produced in Examples 1-14 was used to fill up the depression of a 1 cm-deep concave aluminum panel, and after irradiation with a 1.5 kW halogen lamp for 20 minutes at an irradiation distance of 20 cm and subsequent standing at room temperature, the cured product was released from the aluminum panel, after which the hardness of the front (light-irradiated side) and the back (back of the light-irradiated side) was measured with a soft Barcol hardness tester (Model GYZJ 936, product of Barber Colman Company). The volume shrinkage rates were also determined by the specific gravity of the compositions produced in Examples 1-14 and their cured products. The results are shown in Table 3.

Each of the compositions produced in Comparative Examples 1, 2, 4 and 5 were used to fill up the depression of a 1 cm-deep concave aluminum panel, and after irradiation with a 100 W high-pressure mercury lamp for 60 minutes

at an irradiation distance of 4 cm and subsequent standing at room temperature, the cured product was released from the aluminum panel, after which the hardness of the front (light-irradiated side) and the back (back of the light-irradiated side) was measured with a soft Barcol hardness tester. The results are shown in Fig. 3.

Table 3

| Example No. | Curing experiment results | | | | | | |
|---|---|---|---|---|---|---|---|
| | Barcol hardness | | | | | | Volume shrinkage upon polymerization (%) |
| | immediately after kneading | | 3 months after kneading | | 6 months after kneading | | |
| | (front) | (back) | (front) | (back) | (front) | (back) | |
| 1 | 50 | 48 | 50 | 47 | 50 | 46 | 5.5 |
| 2 | 50 | 48 | 50 | 47 | 50 | 46 | 5.5 |
| 3 | 50 | 48 | 50 | 47 | 50 | 46 | 5.5 |
| 4 | 70 | 65 | 70 | 64 | 70 | 63 | 8.5 |
| 5 | 70 | 65 | 70 | 65 | 70 | 64 | 8.5 |
| 6 | 70 | 65 | 70 | 64 | 70 | 63 | 8.5 |
| 7 | 70 | 65 | 70 | 64 | 70 | 63 | 7.5 |
| 8 | 70 | 65 | 70 | 65 | 70 | 64 | 7.5 |
| 9 | 65 | 64 | 65 | 64 | 65 | 63 | 8.5 |
| 10 | 65 | 64 | 65 | 64 | 65 | 63 | 8.5 |
| 11 | 65 | 64 | 65 | 64 | 65 | 63 | 8.5 |
| 12 | 65 | 63 | 65 | 63 | 65 | 63 | 8.5 |
| 13 | 50 | 49 | 50 | 48 | 50 | 48 | 4.5 |
| 14 | 50 | 49 | 50 | 48 | 50 | 48 | 4.5 |
| Co. 1 | 50 | not measurable | 50 | not measurable | 50 | not measurable | |
| Co. 2 | 70 | not measurable | 70 | not measurable | 70 | not measurable | |
| Co. 4 | 70 | not measurable | 70 | not measurable | 70 | not measurable | |
| Co. 5 | 65 | not measurable | 65 | not measurable | 65 | not measurable | |

Performance test for test coated panels

Preparation of coated panels:

The surfaces of an aluminum panel (JIS. H. 4000, product of Nippon Test Panel Ind. Co.), iron panel (SPCC-SB, product of Nippon Test Panel Ind. Co.), zinc-treated panel (SPGC, product of Nippon Test Panel Ind. Co.) and electrical zinc-treated panel (Silver alloy, product of Japan Steel Corp.) were lightly abraded with water-resistant paper #150 to prepare 4 types of test panels.

Preparation of test coated panels:

The compositions produced in Examples 1-14 were used to coat the above-mentioned test panels with a spatula to a thickness of 5 mm, and then a 1.5 kW halogen lamp was used for 10 minute irradiation at an irradiation distance of 20 cm. The performance test results of the resulting test panels shown in Table 4 are for compositions which were cured immediately after kneading, and those shown in Table 5 are for compositions which were cured after being stored in darkness at 25˚C for 6 months after kneading.

Table 4

| Example No. | Performance test results | | | | | | | |
|---|---|---|---|---|---|---|---|---|
| | Dryness | Adhesion | | | | Abradability | Water resistance | |
| | | Aluminum panel | Iron panel | Zinc-treated panel | Electrical zinc-treated panel | | Blistering | Bending |
| 1 | ○ | Δ | ○ | × | × | ○ | ○ | ○ |
| 2 | ○ | Δ | ○ | × | × | ○ | ○ | ○ |
| 3 | ○ | Δ | ○ | × | × | ○ | ○ | ○ |
| 4 | Δ | ○ | ○ | ○ | ○ | ○ | ○ | ○ |
| 5 | Δ | ○ | ○ | ○ | ○ | ○ | ○ | ○ |
| 6 | Δ | ○ | ○ | ○ | ○ | ○ | ○ | ○ |
| 7 | ○ | Δ | ○ | × | × | ○ | ○ | ○ |
| 8 | ○ | Δ | ○ | × | × | ○ | ○ | ○ |
| 9 | ○ | ○ | ○ | ○ | ○ | ○ | ○ | ○ |
| 10 | ○ | ○ | ○ | ○ | ○ | ○ | ○ | ○ |
| 11 | ○ | ○ | ○ | ○ | ○ | ○ | ○ | ○ |
| 12 | ○ | ○ | ○ | ○ | ○ | ○ | ○ | ○ |
| 13 | ○ | ○ | ○ | ○ | ○ | ○ | ○ | ○ |
| 14 | ○ | ○ | ○ | ○ | ○ | ○ | ○ | ○ |

Table 5

| Example No. | Performance test results | | | | | | | |
|---|---|---|---|---|---|---|---|---|
| | Dryness | Adhesion | | | | Abradability | Water resistance | |
| | | Aluminum panel | Iron panel | Zinc-treated panel | Electrical zinc-treated panel | | Blistering | Bending |
| 1 | ○ | Δ | ○ | × | × | ○ | ○ | ○ |
| 2 | ○ | Δ | ○ | × | × | ○ | ○ | ○ |
| 3 | ○ | Δ | ○ | × | × | ○ | ○ | ○ |
| 4 | Δ | ○ | ○ | ○ | ○ | ○ | ○ | ○ |
| 5 | Δ | ○ | ○ | ○ | ○ | ○ | ○ | ○ |
| 6 | Δ | ○ | ○ | ○ | ○ | ○ | ○ | ○ |
| 7 | ○ | Δ | ○ | × | × | ○ | ○ | ○ |
| 8 | ○ | Δ | ○ | × | × | ○ | ○ | ○ |
| 9 | ○ | ○ | ○ | ○ | ○ | ○ | ○ | ○ |
| 10 | ○ | ○ | ○ | ○ | ○ | ○ | ○ | ○ |
| 11 | ○ | ○ | ○ | ○ | ○ | ○ | ○ | ○ |
| 12 | ○ | ○ | ○ | ○ | ○ | ○ | ○ | ○ |
| 13 | ○ | ○ | ○ | ○ | ○ | ○ | ○ | ○ |
| 14 | ○ | ○ | ○ | ○ | ○ | ○ | ○ | ○ |

Test method:

(1) Dryness: The surface tack and internal hardness of the test panels were determined by finger touch.

○ No surface tack, satisfactory internal hardness
Δ Slight surface tack but satisfactory internal hardness
x No surface tack and poor internal hardness

(2) Adhesion: The adhesion of the cured products to the test panels upon bending at a 90˚ angle from the center was evaluated in the following manner.

○ Adhesion of cured product
Δ 50% to 90% adhesion of cured product
× Less than 50% adhesion of cured product

(3) Abradability: The surfaces of the test panels were abraded with water-resistant paper #150, and the ease of abrasion of each was compared and evaluated in the following manner.

○ Cured product coating removed readily even with light abrasion
Δ Cured product coating removed, but somewhat heavy abrasion required
× Heavy abrasion, low removal of cured product coating

(4) Water resistance: A test coated panel prepared by the method described above using an iron test panel (SPCC-SB, product of Nippon Test Panel Ind. Co.), was abraded in order with water-resistant paper #240, #150 and #400 to smooth the surface. The abraded putty coating was then spray coated (dry film thickness: 50 μm) with a commercially available acrylurethane paint (tradename: Highart, product of Isamu Paint Co.), and after standing at room temperature (20˚C) for 30 minutes, it was dried for 60 minutes in a drier at 60˚C. After cooling, it was placed in a blistering box (RH 99%, temperature: 50˚C) for 48 hours, and the condition of the coated surface (blisters, foaming approximately 2 mm in diameter) and the adhesion of the cured product upon bending at a 90˚ angle were examined. The blistering was evaluated in the following manner, and the adhesion of the cured product was evaluated as in (2) above.

○ No blistering
Δ Blistering of at least 50% of the coating

The results of the examples demonstrated that the hardness of the cured product of 1 cm thickness was expressed on both the front and back sides, while only the examples exhibited no change in the curability of the compositions immediately after filling and the curability after dark storage at room temperature for 3 months after filling. As shown by the results in Table 3, only the examples exhibited satisfactory expression of the curing performance (dryness, adhesion, abradability, water resistance).

According to the present invention, a bisacylphosphine oxide compound represented by general formula (1) and/or an acylphosphine oxide compound represented by general formula (2) is used as the polymerization initiator to allow expression of sufficient hardness on both the front and back sides which comprise the polymerizable compound and if necessary a filler, and there may be provided compositions suitable for one-pack type putty materials with storage stability of 6 months and longer at room temperature, as well as a curing process therefor.

## Claims

1. A photocurable composition comprising a bisacylphosphine oxide compound of general formula (1) or an acylphosphine oxide compound of general formula (2), and a polymerizable unsaturated compound,

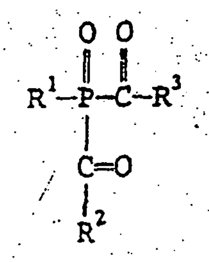

(1)

wherein $R^1$, $R^2$ and $R^3$ each Independently represent an alkyl group, aryl group, aralkyl group, alkenyl group, alkynyl group, heterocyclic group, substituted alkyl group, substituted aryl group, substituted aralkyl group, substituted alkenyl group, substituted alkynyl group or substituted heterocyclic group,

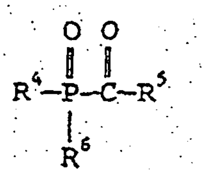

(2)

wherein $R^4$, $R^5$ and $R^6$ each independently represent an alkyl group, aryl group, aralkyl group, alkenyl group, alkynyl group, heterocyclic group, substituted alkyl group, substituted aryl group, substituted aralkyl group, substituted alkenyl group, substituted alkynyl group or substituted heterocyclic group, **characterized in that** the hardness of the cured product of the cured composition at 25°C as measured with a soft Barcol hardness tester (Model GYZJ 936) is in the range of 1-85 and the photocurable composition is a putty material, said composition
further comprising a compound with photosensitivity in the visible light and near infrared light region and/or organic filler,
wherein the compound with sensitivity in the visible light and near infrared light region is a combination of a cationic dye represented by general formula (3) with absorption in the visible light and/or near infrared light region, and a boron-containing compound represented by general formula (4).

$$D^+ \cdot A^- \qquad (3)$$

wherein $D^+$ represents a cationic dye with absorbance in the visible light and/or near infrared light region, and $A^-$ represents any anion.

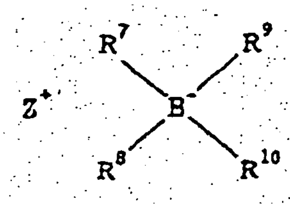

(4)

wherein $Z^+$ represents a cation, and $R^7$, $R^8$, $R^9$ and $R^{10}$ each Independently represent an alkyl group, aryl group, aralkyl group, alkenyl group, alkynyl group, silyl group, heterocyclic group, halogen atom, substituted alkyl group, substituted aryl group, substituted aralkyl group, substituted alkenyl group, substituted alkynyl group or substituted silyl group.

**2.** A curing process comprising curing a composition according to claim 1, after filling, by irradiation of light of the sensitive wavelength of the compounds in the composition.

**Patentansprüche**

**1.** Photohärtbare Zusammensetzung, die eine Bisacylphosphinoxid-Verbindung der allgemeinen Formel (1) oder eine Acylphosphinoxid-Verbindung der allgemeinen Formel (2) und eine polymerisierbare, ungesättigte Verbindung enthält,

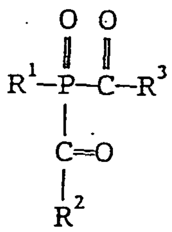

(1)

worin $R^1$, $R^2$ und $R^3$ jeweils unabhängig voneinander eine Alkylgruppe, Arylgruppe, Aralkylgruppe, Alkenylgruppe, Alkinylgruppe, heterocyclische Gruppe, substituierte Alkylgruppe, substituierte Arylgruppe, substituierte Aralkylgruppe, substituierte Alkenylgruppe, substituierte Alkinylgruppe oder substituierte heterocyclische Gruppe darstellen,

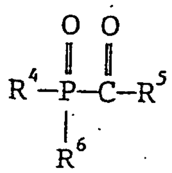

(2)

worin $R^4$, $R^5$ und $R^6$ jeweils unabhängig voneinander eine Alkylgruppe, Arylgruppe, Aralkylgruppe, Alkenylgruppe, Alkinylgruppe, heterocyclische Gruppe, substituierte Alkylgruppe, substituierte Arylgruppe, substituierte Aralkylgruppe, substituierte Alkenylgruppe, substituierte Alkinylgruppe oder substituierte heterocyclische Gruppe darstellen, **dadurch gekennzeichnet, daß** die Härte des Härtungsprodukts der gehärteten Zusammensetzung bei 25°C, gemessen mit einem Barcol-Härtetester für niedere Härte (Modell GYZJ 936) im Bereich von 1 bis 85 ist und daß die photohärtbare Zusammensetzung eine Kittmasse ist, wobei die Zusammensetzung außerdem eine Verbindung, die im Bereich des sichtbaren Lichts und des nahen Infrarotlichts photoempfindlich ist, und einen anorganischen und/oder organischen Füllstoff enthält, wobei die Verbindung mit Empfindlichkeit im Bereich des sichtbaren Lichts und nahen Infrarotlichts eine Kombination aus einem durch die allgemeine Formel (3) dargestellten kationischen Farbstoff mit Absorption im Bereich des sichtbaren Lichts und/oder nahen Infrarotlichts und einer Borverbindung der allgemeinen Formel (4) ist

$$D^+ \cdot A^- \qquad (3)$$

worin $D^+$ einen kationischen Farbstoff mit Absorption im Bereich des sichtbaren Lichts und/oder nahen Infrarotlichts darstellt und $A^-$ ein Anion darstellt

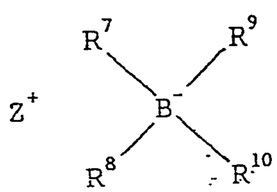

(4)

worin $Z^+$ ein Kation bedeutet und $R^7$, $R^8$, $R^9$ und $R^{10}$ jeweils unabhängig voneinander eine Alkylgruppe, Arylgruppe, Aralkylgruppe, Alkenylgruppe, Alkinylgruppe, Silylgruppe, heterocyclische Gruppe, ein Halogenatom, eine substituierte Alkylgruppe, substituierte Arylgruppe, substituierte Aralkylgruppe, substituierte Alkenylgruppe, substituierte Alkinylgruppe oder substituierte Silylgruppe darstellen.

**2.** Härtungsverfahren, welches die nach dem Füllen durchgeführte Härtung einer Zusammensetzung nach Anspruch 1 durch Bestrahlen mit Licht einer Wellenlänge umfasst, bei der die Verbindungen in der Zusammensetzung empfindlich sind.

## Revendications

**1.** Composition photodurcissable comprenant un composé oxyde de bisacylphosphine de formule générale (1), ou un composé oxyde d'acylphosphine de formule généréle (2), et un composé insaturé polymérisable,

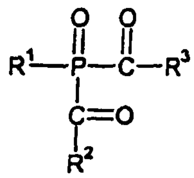

(1)

où chacun de $R^1$, $R^2$ et $R^3$ représente indépendamment un groupe alkyle, un groupe aryle, un groupe aralkyle, un groupe alcényle, un groupe alcynyle, un groupe hétérocyclique, un groupe alkyle substitué, un groupe aryle substitué, un groupe aralkyle substitué, un groupe alcényle substitué, un groupe alcynyle substitué ou un groupe hétéroyclique substitué,

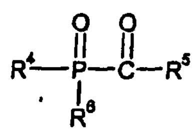

(2)

où chacun de $R^4$, $R^5$ et $R^6$ représente indépendamment un groupe alkyle, un groupe aryle, un groupe aralkyle, un groupe alcényle, un groupe alcynyle, un groupe hétérocyclique, un groupe alkyle substitué, un groupe aryle substitué, un groupe aralkyle substitué, un groupe alcényle substitué, un groupe alcynyle substitué ou un groupe hétérocyclique substitué,
**caractérisée en ce que** la dureté du produit durci de la composition durcie à 25°C, telle que mesurée avec un testeur de dureté Barcol souple (modèle GYZJ 936), est située dans la plage allant de 1 à 85, et **en ce que** la composition composition photodurcissable est un matériau mastic, ladite composition comprenant en outre un composé présentant une photosensibilité dans la région de la lumière visible et dans la région de la lumière du proche infrarouge et une charge minérale et/ou organique,
dans laquelle le composé présentant une photosensibilité dans la région de la lumière visible et dans la région de la lumière du proche infrarouge est une combinaison d'un pigment cationique représenté par la formule générale (3) ayant une absorption dans la région de la lumière visible et/ou dans la région de la lumière du proche infrarouge, et d'un composé contenant du bore représenté par la formule générale (4) :

$$D^+ \cdot A^- \qquad (3)$$

où $D^+$ représente un pigment cationique ayant une absorbance dans la région de la lumière visible et/ou dans la région de la lumière du proche infrarouge, et $A^-$ représente un anion quelconque ;

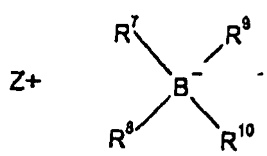

(4)

où $Z^+$ représente un cation, et chacun de $R^7$, $R^8$, $R^9$ et $R^{10}$ représente indépendemment un groupe alkyle, un groupe aryle, un groupe aralkyle, un groupe alcényle, un groupe alcynyle, un groupe silyle, un groupe hétérocyclique, un atome d'halogène, un groupe alkyle substitué, un groupe aryle substitué, un groupe aralkyle substitué, un groupe alcényle substitué, un groupe alcynyle substitué ou un groupe silyle substitué.

**2.** Procédé de durcissement comprenant le durcissement d'une composition selon la revendication 1, après charge, par irradiation de lumière de la longueur d'onde sensible des composés dans la composition.